# EUROPEAN PATENT APPLICATION

(11) **EP 4 507 007 A1**
(43) Date of publication of application: **12.02.2025**
(21) Application number: 23190924.3
(22) Date of filing: 10.08.2023
(51) Int. Cl.: H01L 29/08, H01L 23/31, H01L 29/10, H01L 29/778, H01L 29/40, H01L 21/337, H01L 29/20

(54) **METHOD FOR FABRICATING A SEMICONDUCTOR DEVICE**

(71) Applicant: Infineon Technologies Austria AG, 9500 Villach (AT)
(72) Inventor: OSTERMAIER, Clemens, 9500 Villach (AT); DELLAS, Nicholas Stephen, 9500 Villach (AT)
(74) Representative: JENSEN & SON

(57) **Abstract**

According to the invention, a method is provided which comprises providing a Group III nitride-based substrate comprising a first major surface and at least one doped Group III nitride region comprising dopants of a first conductivity type, forming a first passivation layer on the first major surface, wherein the first passivation layer is configured as a hydrogen diffusion barrier, forming at least one first opening in the first passivation layer and exposing at least a portion of the at least one doped Group III nitride region from the first passivation layer, activating the first doped Group III nitride region whilst the first passivation layer is located on the first major surface and the at least a portion of the at least one doped Group III nitride region is exposed from the first passivation layer, forming a second passivation layer on the first passivation layer and on the at least one doped Group III nitride region, forming at least one second opening in the first and second passivation layers and exposing a portion of the at least one doped Group III nitride region and forming a contact in the second opening.

## Description

### BACKGROUND

To date, transistors used in power electronic applications have typically been fabricated with silicon (Si) semiconductor materials. Common transistor devices for power applications include Si CoolMOSO, Si Power MOSFETs, and Si Insulated Gate Bipolar Transistors (IGBTs). More recently, silicon carbide (SiC) power devices have been considered. Group III-N semiconductor devices, such as gallium nitride (GaN) transistor devices, are now emerging as attractive candidates to carry large currents, support high voltages and to provide very low on-resistance and fast switching times.

A passivation layer on the semiconductor device is used to protect the semiconductor device from hostile environmental conditions. WO 2005/117129 A1 describes dielectric passivation schemes for Group III nitride-based semiconductor devices. The passivation layer or layers may also be used to mitigate the effects of surface charges which can hinder proper modulation of the conductive channel by the gate. Further improvements to the passivation of Group III nitride devices are desirable.

### SUMMARY

According to the invention, a method is provided which comprises providing a Group III nitride-based substrate comprising a first major surface and at least one doped Group III nitride region comprising dopants of a first conductivity type, forming a first passivation layer on the first major surface, forming at least one first opening in the first passivation layer and exposing at least a portion of the at least one doped Group III nitride region from the first passivation layer, activating the first doped Group III nitride region whilst the first passivation layer is located on the first major surface and the at least a portion of the at least one doped Group III nitride region is exposed from the first passivation layer, forming a second passivation layer on the first passivation layer and on the at least one doped Group III nitride region, forming at least one second opening in the first and second passivation layers and exposing a portion of the at least one doped Group III nitride region and forming a contact in the second opening. The first passivation layer may be configured as a hydrogen diffusion barrier.

According to the invention, a semiconductor device is provided which comprises a Group III nitride substrate comprising a first major surface, at least one doped Group III nitride region formed in or on the first major surface, a first passivation layer arranged on the first major surface and on a peripheral region of the doped Group III nitride region such that a central portion of the doped Group III nitride region is uncovered by the first passivation layer and a metallic contact arranged in contact with the doped Group III nitride region and extending over the first passivation layer. The first passivation layer may be configured as a hydrogen diffusion barrier.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1A illustrates a cross-sectional view of a semiconductor device according to an embodiment.
Figure 1B illustrates a cross-sectional view of a semiconductor device according to an embodiment.
Figure 2, which includes figures 2A to 2I, illustrates a method of fabricating a semiconductor device.
Figure 3 illustrates a cross-sectional view of a semiconductor device according to an embodiment.
Figure 4 illustrates a flow diagram of a method of fabricating a Group III nitride semiconductor device.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

A depletion-mode transistor device has a negative threshold voltage which means that it can conduct current at zero gate voltage. These devices are normally on. An enhancement-mode transistor device has a positive threshold voltage which means that it cannot conduct current at zero gate voltage and is normally off.

As used herein, the phrase "Group III-Nitride" refers to a compound semiconductor that includes nitrogen (N) and at least one Group III element, including aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), and aluminum indium gallium arsenide phosphide nitride (AlₓIn_{y}Ga_{(1-x-y)}AsₐP_{b}N_{(1-a-b)}), for example. Aluminum gallium nitride and AlGaN refers to an alloy described by the formula AlₓGa₍₁₋ₓ₎N, where 0 < x < 1.

According to the invention, an improved passivation scheme for use in lateral Group III nitride devices, e.g. lateral GaN HEMTs and method for fabricating lateral Group III nitride devices, e.g. lateral GaN HEMTs is provided.

Some Group III nitride devices, such as lateral GaN transistor devices and lateral GaN bidirectional switches, include a AlGaN barrier layer on a GaN channel layer so that a heterojunction is formed between the AlGaN barrier layer and the GaN channel layer that is capable of supporting a two-dimensional charge gas such as a two-dimensional electron gas (2DEG). The surface passivation of the AlGaN barrier layer is thought to constitute a region of donor states which influence the 2DEG formed at the heterojunction between the GaN channel layer and AlGaN barrier layer. Under off-state or semi-on state conditions, trapping in this surface region may cause depletion of the 2DEG, which can result in drift and degradation in the device.

The method includes forming a suitable passivation layer or layers for devices which include a p-doped Group III nitride region such as a pGaN region. A p-doped Group III nitride region may be used in a gate structure for forming an enhancement mode HEMT or may be used in a power contact, e.g. a contact to the 2DEG such as a source contact and/or a drain contact of a transistor device such as a HEMT, or an in/out power contact of a bi-directional switch.

According to embodiments of methods described herein, the passivation layer is formed after formation of the p-doped Group III nitride region(s) and prior to the activation of the p-doped Group III nitride region. This order allows for more independence in optimizing the activation process.

In an embodiment, the gate structure including a p-doped Group III nitride region is fabricated by etching to form a recess in the AlGaN barrier layer and selective regrowth to form p-doped Group III nitride material in the recess. Alternatively, the gate structure including a p-doped Group III nitride region is fabricated by depositing p-doped Group III nitride region on the planar surface of the AlGaN barrier layer. In a further alternative embodiment, a p-doped Group III nitride region may be formed by implantation of p-type dopants into the Group III nitride substrate.

Subsequently, the surface of the substrate, e.g. the AlGaN barrier layer, is passivated by forming a first dielectric layer on the surface of the substrate. This first level passivation layer may act as a hydrogen barrier preventing diffusion of hydrogen during further processing of the substrate. The regions of the substrate that require activation, e.g. the deposited p-doped Group III nitride region of the gate, or implanted p-doped regions for forming electrical contacts e.g. the source and drain, are opened, i.e. at least partly exposed from the first dielectric layer. In some embodiments, the peripheral region of the p-doped Group III nitride region remains covered by the first passivation layer. This opening can be performed by wet and/or dry etching. Not every region p-doped Group III nitride region needs to be opened. For example, a pGaN region could be used also as H-passivated layer behaving rather like undoped GaN. The exposed surface is exposed to a typical high temperature activation process, e.g. thermal annealing. Then, the metallic source/drain and gate contacts are formed.

The passivation method requires only exposure of the surface region used for contacting and thus prevents damage creation during activation in any region outside the exposed region (s). Transistor devices fabricated using this method have reduced gate leakage currents, e.g. by a factor 10 or more. This suggests a strong improvement in the side wall quality resulting from the passivation of the gate structure prior to activation and the second passivation process.

Subsequent to the activation, in some embodiments, the surface is again passivated with a second dielectric layer by depositing a second dielectric layer on the first dielectric layer which is also located in the openings in the first dielectric layer. The second dielectric layer may form part of a metallization structure. The opening formed through the second and first passivation layer exposes at least a part of the p-doped Group III nitride region. Such an additional dielectric deposition should not reintroduce hydrogen into the activated p-doped Group III nitride regions. The second dielectric layer is however not relevant for defining the main region of the surface passivation. The structuring of the first dielectric layer and second dielectric layer (if used) may or may not include wet etching in addition to dry etching, e.g. plasma etching. Each of the first and second dielectric layers may be formed of a single layer or may comprise two or more sublayers. Then, the metallic source/drain and gate contacts are formed.

In this method, all the contacts are passivated and opened twice in two independent steps. Therefore, both dielectric layers and the first passivation process, e.g. the formation of the first dielectric layer prior to activation, and the second passivation process, i.e. formation of the second dielectric layer after activation, can be optimized for their respective roles.

In an embodiment, a SiNₓ layer is used for the first dielectric layer in order to protect the surface prior to activation. This SiNₓ layer is formed by LPCVD (Low Pressure

Chemical Vapour Deposition) and is deposited first to protect the surface, structured to produce an opening located above the desired position of each of one or more of the gate and/or source and drain contact regions and then the activation of the p-doped Group III nitride regions is carried out. In the final device, the SiN layer formed by LPCVD may be the only material in contact with the Group III- nitride layer.

As an alternative to SiN_{x and} LPCVD SiNₓ, other dielectric materials such as AlOₓ, SiOₓ, ZrOₓ, AlN, SiON, GaOₓ, AlGaON may be used. For first level passivation layers with relatively low wet etch rate e.g. LPCVD SiN, the resist adhesion may not endure the long wet etch time needed. For these materials it may be useful to structure the passivation layer not only by wet etching but also dry etching. For example, the SiN passivation may be partially dry etched without reaching the underlying surface, e.g. AlGaN barrier layer, to form a recess and then wet etched. In some embodiments, the wet etching is carried out without a structured resist so that the entire dielectric layer is thinned by the wet etching process. After wet etching, a thinned down dielectric layer remains in the regions that were not previously dry etched and an open exposed surface is formed in those regions partially recessed by dry etching.

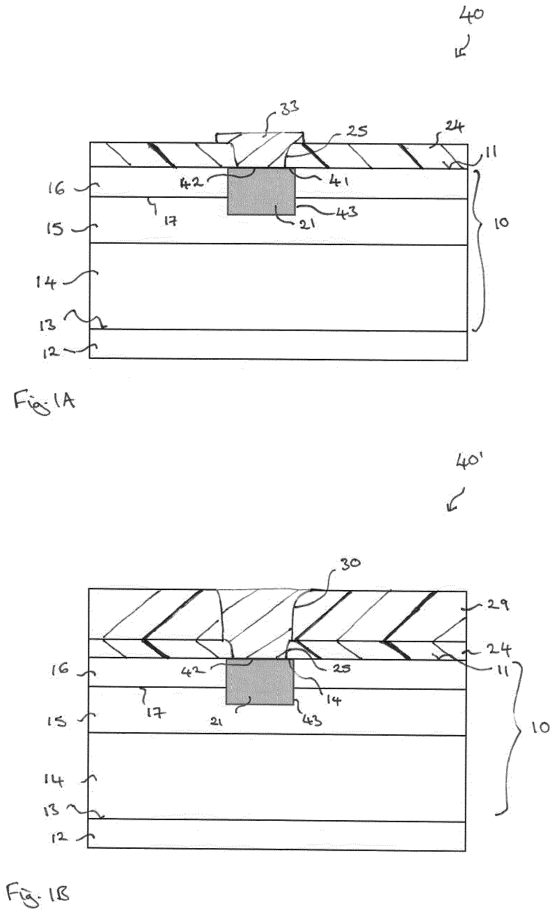

Figure 1A illustrates a cross-sectional view of a semiconductor device 40 which comprises a Group III nitride substrate 10 comprising a first major surface 11, at least one doped Group III nitride region 21 formed in or on the first major surface 11. The doped Group III nitride region 21 comprises dopants of a first conductivity type, for example p-type. An example of a p-type dopant is Mg. The doped Group III nitride region 21 may be formed by implantation of dopants of the first conductivity type into undoped or intrinsically doped Group III nitride material of the substrate 10 or by growth of doped Group III nitride material onto the first major surface 11 or into a recess 43 formed in the first major surface 11.

Referring to figure 1A, in this embodiment, the Group III nitride-based substrate 10 comprises a base substrate 12 having a first main surface 13 which is capable of supporting the epitaxial growth of one or more Group III nitride layers. The base substrate 12 may be formed of a material other than a Group III nitride and may be formed of formed of monocrystalline silicon, for example a monocrystalline silicon wafer or an epitaxial silicon layer, or may be formed of SiC or sapphire.

A Group III nitride buffer structure 14 is located on the first main surface 13 of the base substrate 12, a Group III nitride channel layer 15 is located on the buffer layer 14 and a Group III nitride barrier layer 16 is located on the Group III nitride channel layer 15. The Group III nitride channel layer 15 and the Group III nitride barrier layer 16 have different compositions and differing bandgaps say that a heterojunction 17 is formed between the Group III nitride barrier layer 16 of the Group III nitride channel layer 15. In some embodiments, the Group III nitride channel layer 15 is formed of gallium nitride and the Group III nitride barrier layer 16 is formed of aluminium gallium nitride (AlGaN), whereby AlGaN refers to a ternary alloy described by the formula AlₓGa₍₁₋ₓ₎N, where 0 < x < 1, so that the heterojunction 17 is capable of supporting a two-dimensional charge carrier gas such as a two-dimensional electron gas (2DEG). The Group III nitride barrier layer 16 provides the first major surface 11 of the Group III nitride substrate 10. The buffer structure 14, GaN channel layer 15 and AlGaN barrier layer 16 are epitaxially grown in this order on the growth surface 13 of the base substrate 12.

A typical transition or buffer structure 14 for a silicon substrate 12 includes a AlN starting layer, which may have a thickness of several 100nm, on the silicon base substrate 12 followed by a AlₓGa₍₁₋ₓ₎N layer sequence, the thickness again being several 100nm's for each layer, whereby the Al content of about 50-75% is decreased down to 10-25% before the GaN layer or AlGaN back barrier, if present, is grown. Alternatively, a superlattice buffer can be used. Again, an AlN starting layer on the silicon substrate is used. Depending on the chosen superlattice, a sequence of AlN and AlₓGa₍₁₋ₓ₎N pairs is grown, where the thickness of the AlN layer and AlₓGa₍₁₋ₓ₎N is in the range of 2-25nm. Depending on the desired breakdown voltage the superlattice may include between 20 and 100 pairs. Alternatively, an AlₓGa₍₁₋ₓ₎N layer sequence as described above can be used in combination with the above mentioned superlattice.

In some non-illustrated embodiments, a back barrier layer is formed between the buffer structure 14 and the Group III nitride channel layer 15. The channel layer 15 is formed on the back barrier layer and forms a heterojunction with the back barrier layer and the barrier layer 16 is formed on channel layer 15. The back barrier layer has a different bandgap to the channel layer and may comprise AlGaN, for example. The composition of the AlGaN of the back barrier layer may differ from the composition of the AlGaN used for the barrier layer 16.

A first passivation layer 24 is arranged on the first major surface 11 of the Group III nitride substrate 10 which is formed by the Group III nitride barrier layer 16. The first passivation layer 24 is located on a peripheral region 41 of the doped Group III nitride region 21 such that a central portion 42 of the doped Group III nitride region 21 is uncovered by the first passivation layer 24. The first passivation layer 24 can be considered to have an opening 25 which exposes the central portion 42 of the doped Group III nitride region 21. The remainder of the first major surface 11 is covered by and in direct contact with the first passivation layer 24. A metallic contact 33 is arranged in the opening 30 in the first passivation layer 24 and is in direct contact with the exposed central portion 42 of the doped Group III nitride region 21. In this embodiment, the metallic contact 33 also extends over the upper surface of the first passivation layer 24. The first passivation layer 24 comprises a dielectric material and is configured as a hydrogen diffusion barrier. The first passivation layer 24 may comprise SiNₓ, e.g. Si₃N₄ or may comprise Al₂O₃ or La₂O₃ or ZrO₂. The first passivation layer may have a thickness of 5 nm to 30 nm.

In some embodiments, the first passivation layer 24 is formed of SiNₓ and comprises a silicon : nitrogen atomic ratio within 2 percent of the ratio 3:4. Optionally, the fist passivation layer 24 further comprises a stress of 600 megapascals (MPa) to 1000 MPa; and a hydrogen content of less than 5 atomic percent. In some embodiments, the silicon nitride layer has an index of refraction of 2.0 to 2.1. The first passivation layer 24 may have a dielectric breakdown strength of greater than 12 megavolts per centimetre (MV/cm).

Figure 1B illustrates a cross-sectional view of a semiconductor device 40' according to an embodiment which differs from that illustrated in figure 1A in that it further comprises a second passivation layer 29 that is arranged on the first passivation layer 24. In this particular embodiment, the first passivation layer 24 is formed of Si₃N₄ and the second passivation layer 29 is formed of SiO₂. The second passivation layer 29 includes an opening 30 that is located above the opening 25 in the first passivation layer 24 such that an opening is formed through the first and second passivation layers 24, 29 which exposes the central portion 42 of the doped Group III nitride region 21. The peripheral region 41 of the doped Group III nitride region 21 is covered by and in direct contact with the first passivation layer 24. Only the first passivation layer 24 is in direct contact with the Group III nitride substrate 11. The second passivation layer 29 may be formed of an oxide, e.g a silicon oxide, and may form part of a metallization structure formed on the first major surface 11.

In some embodiments, the doped Group III nitride region 21 comprises a doped Group III nitride layer that is arranged in a recess 43 formed in the first major surface 11. In some non-illustrated embodiments, the doped Group III nitride region 21 is arranged on a planar first major surface 11. The doped Group III nitride region 21 may be configured as part of a gate structure of a transistor device or a bidirectional switch to form a n enhancement mode device. Alternatively, the doped Group III nitride region 21 may be configured as a contact, for example a contact to a channel of a transistor device or bidirectional switch, such as a 2DEG.

The semiconductor device 40, 40' may also include more than one doped Group III nitride region 21. In some embodiments, the semiconductor device 40, 40' comprises three doped Group III nitride regions, whereby one provides a part of the gate structure and two each provide part of an ohmic contact of a transistor device or a bidirectional switch, e.g. a source contact or a drain contact. The doped Group II nitride regions 21 may have the same or different structures. For example, the doped Group III nitride region for the source and drain contact may be an implanted region of the Group III nitride substrate 11 and the doped Group III nitride region for the gate contact may be a separate deposited doped Group III nitride layer. In some embodiments, the semiconductor device 40, 40' is a HEMT.

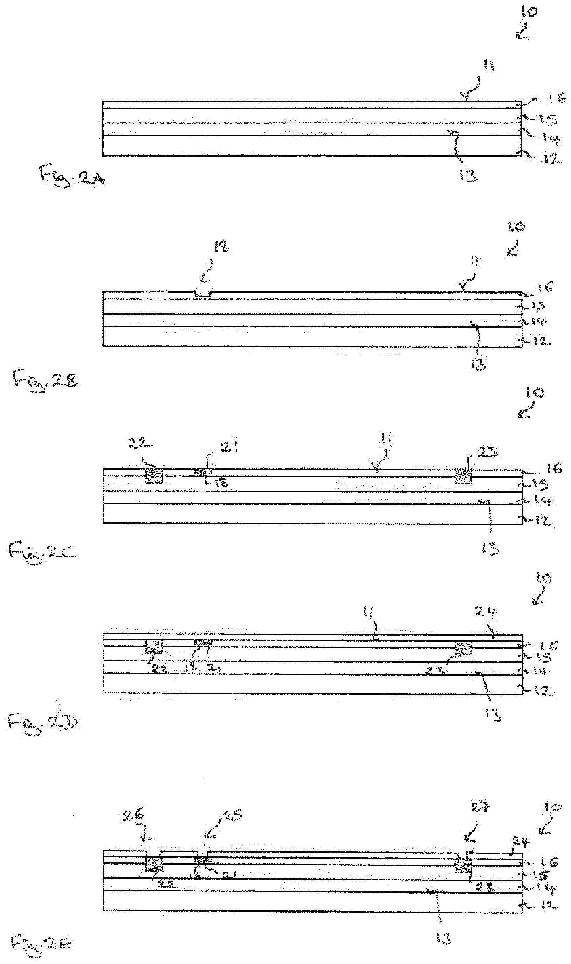

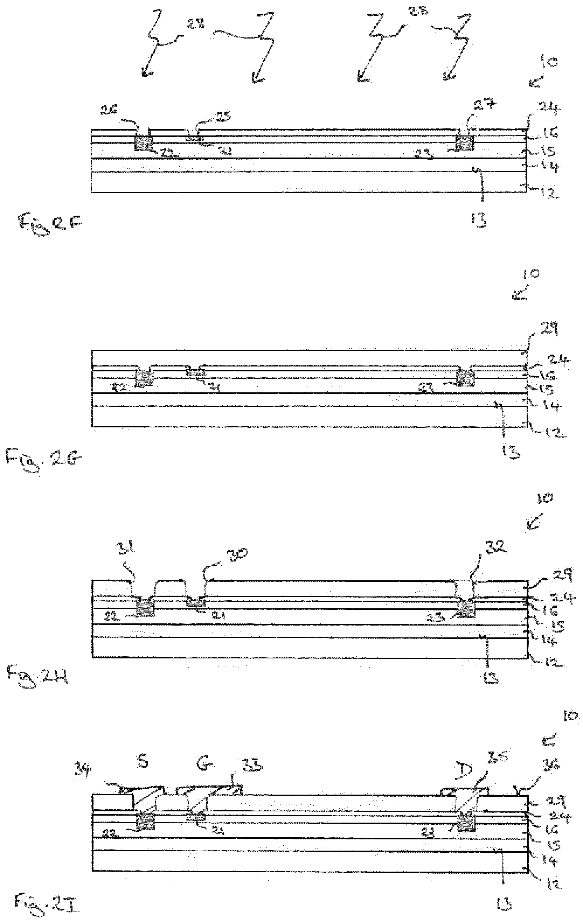

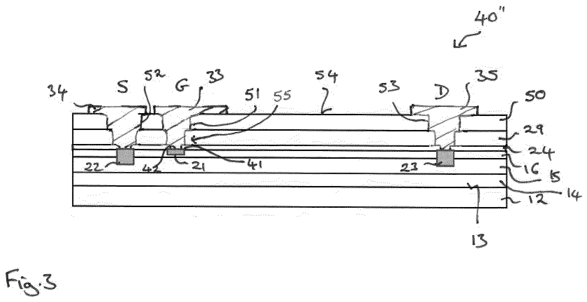

Figure 2 includes figures 2A to 2I and illustrates a method for fabricating a contact to a Group III nitride device. The method will be illustrated for fabricating a metal gate contact to a Group III nitride device and for fabricating a source contact or a drain contact to a transistor device. The method may also be used for fabricating an ohmic contact to a Group III nitride layer such as an ohmic source contact, an ohmic drain contact of a transistor device or a power contact of a bidirectional switch, e.g. an ohmic power contact of a bidirectional switch. However, the method may be used for forming a single type of contact, e.g. a gate contact. The method may be used to fabricate the device illustrated in and described with reference to figure 1A, figure 1B or figure 3.

Figure 2A illustrates a Group III nitride-based substrate 10 which includes a first major surface 11. In this embodiment, the Group III nitride-based substrate 10 comprises a base substrate 12 having a first main surface 13 which is capable of supporting the epitaxial growth of one or more Group III nitride layers. The base substrate 12 may be formed of a material other than a Group III nitride and may be formed of formed of monocrystalline silicon, for example a monocrystalline silicon wafer or an epitaxial silicon layer, or be formed of SiC or Sapphire.

A Group III nitride buffer structure 14 is located on the first main surface 13, a Group III nitride channel layer 15 is located on the buffer layer 14 and a Group III nitride barrier layer 16 is located on the Group III nitride channel layer 15. The Group III nitride channel layer 15 and the Group III nitride barrier layer 16 have different compositions and differing bandgaps say that a heterojunction 17 is formed between the Group III nitride barrier layer 16 of the Group III nitride channel layer 15. In some embodiments, the Group III nitride channel layer 15 is formed of gallium nitride and the Group III nitride barrier layer 16 is formed of aluminium gallium nitride (AlGaN), whereby AlGaN refers to a ternary alloy described by the formula AlₓGa₍₁₋ₓ₎N, where 0 < x < 1, so that the heterojunction 17 is capable of supporting a two-dimensional charge carrier gas such as a two-dimensional electron gas (2DEG). The upper surface of the Group III nitride barrier layer 16 provides the first major surface 11 of the Group III nitride substrate 10. The buffer structure 14, GaN channel layer 15 and AlGaN barrier layer 16 are epitaxially grown in this order on the growth surface 13 of the base substrate 12.

In some non-illustrated embodiments, a back barrier layer is formed between the buffer structure 14 and the Group III nitride channel layer 15 as described with reference to figure 1A. The buffer structure 14 may have the structure described with reference to figure 1A.

Referring to figure 2B, a recess 18 is formed in the first major surface 11 such that the Group III nitride barrier layer 16 has a reduced thickness underneath the base 19 of the recess 18 compared to regions laterally adjacent the recess 18. The recess 18 is used as part of a gate structure for a transistor device or a bidirectional switch.

Referring to figure 2C, the gate recess 18 is filled with a Group III nitride material which comprises dopants of a first conductivity type and forms a first doped Group III nitride region 21. The first conductivity type may be p type and the dopants may be magnesium. In some embodiments, this first doped Group III nitride region 21 may also extend over the first major surface 11 such that the p-doped Group III nitride region 21 has a T-shape in cross-section.

Also referring to figure 2C, a second doped Group III nitride region 22 and a third doped Group III region 33 are formed in the first major surface 11 which extend from the first major surface 11 through the barrier layer 16 and into the channel layer 15. The second and third doped Group III nitride regions 22, 23 may be formed by implanting dopants of the second conductivity type, e.g. Mg, into the first major surface 11 of the Group III nitride-based substrate 10.

The second doped Group III nitride region 22 and the third doped Group III nitride region 23 are arranged laterally adjacent and spaced apart from opposing sides of the first doped region 21. The spacing between the second doped region 22 and the first doped region 21 may be less than the spacing between the first doped region 21 and the third doped region 23 so that the second doped region 22 provides a source contact and the third doped region 23 provides a drain contact of a transistor device. The transistor device may be a high electron mobility transistor (HEMT) device. The second doped region 22 and the third doped region 23 may be doped with the first conductivity type.

Referring to figure 2D, a first passivation layer 24 is formed on the first major surface 11 which also covers the first, second and third doped regions 21, 22, 23 entirely. The first passivation layer 24 is configured as a hydrogen diffusion barrier and may be formed of a dielectric material. Examples of dielectric materials which can serve as a hydrogen diffusion barrier layer include SiNₓ, AlOₓ, SiOₓ, ZrOₓ, AlN, SiON, GaO_{X}, AlGaON The first passivation layer 24 may be formed of silicon nitride, e.g. Si₃N₄, or Al₂O₃ or La₂O₃ or ZrO₂. In some embodiments, the first passivation layer 24 has a thickness of 5 nm to 30 nm.

In an embodiment, the first passivation layer 24 is formed of silicon nitride and is formed by a LPCVD (Low Pressure Chemical Vapour Deposition) process. In some embodiments, the LPCVD process comprises placing the Group III nitride substrate 11 in an LPCVD furnace, heating the Group III nitride substrate 11 to a temperature of 800°C to 820°C in the LPCVD furnace and providing ammonia gas and dichlorosilane gas to a reaction chamber at a ratio of 4 to 6, and at a pressure of 150 millitorr to 250 millitorr.

In some embodiments, the first passivation layer 24 comprises a silicon:nitrogen atomic ratio within 2 percent of the ratio 3:4. In some embodiments, the first passivation layer 24 has a silicon:nitrogen atomic ratio within 2 percent of the ratio 3:4, a stress of 600 megapascals (MPa) to 1000 MPa; and a hydrogen content of less than 5 atomic percent;

In some embodiments, the first passivation layer 24 is formed of silicon nitride and the silicon nitride has an index of refraction of 2.0 to 2.1.

In some embodiments, the first passivation layer 24 has a dielectric breakdown strength of greater than 12 megavolts per centimetre (MV/cm).

Referring to figure 2E, a first opening 25 is formed in the first passivation layer 24 which exposes at least a portion of the first doped region 21. A third opening 26 is formed in the first passivation layer 24 which exposes a portion of the second doped region 22 and a fourth opening 27 is formed in the first passivation layer 24 which exposes a portion of the third doped region 23. The peripheral regions of each of the first, second and third doped Group III nitride regions 21, 22,23 may be covered by the first passivation layer 24 and only the central region exposed by the first passivation layer 24. The first, third and fourth openings 25, 26, 27 may be formed using the same process. For example, a mask of photoresist may be deposited onto the first passivation layer 24, photolithographically structured to form openings and expose regions of the first passivation layer and these exposed regions are etched, e.g. dry and/or wet etched.

Referring to figure 2F, the first, second and third doped regions 21, 22, 23 are activated whilst the passivation layer 24 is located on the first major surface 11 of the Group III nitride-based substrate 10 and whilst at least a portion of the first doped region 21 is exposed by the first opening 25, at least a portion of the second doped region 22 is exposed by the third opening 26 and whilst at least a portion of the third doped region 25 is exposed by the fourth opening 27 in the first passivation layer 24. The remainder of the first major surface 11 provided by the AlGaN barrier layer 16 is covered by the first passivation layer also during activation. The activation is indicated schematically in figure 1F by the arrows 28. The activation may take place by thermally annealing the Group III nitride-based substrate 11. Since the regions of the first major surface 11 outside of the regions exposing the p-doped Group III nitride material which is to be activated are covered by the passivation layer 24, the remaining passivation layer 24 hinders the diffusion of hydrogen into the Group III nitride substrate 10 and into these p-doped regions 21, 22, 23. Consequently, there is a reduced likelihood of hydrogen combining with the dopants of the second conductivity type and reducing the effective doping level of the p-doped regions 21, 22, 23.

Referring to figure 2G, a second passivation layer 29 is then formed on the first passivation layer 24, into the openings 25, 26, 27 and on the exposed portions of the first, second and third doped Group III nitride regions 21, 22 and 23.

In some embodiments, the second passivation layer 29 is formed of SiO₂. In one particular embodiment, the second passivation layer 29 is formed of SiO₂ and the first passivation layer 24 is formed of Si₃N₄.

Referring to figure 2H, a second opening 30 is formed in the second passivation layer 21 at a location above the first doped Group III nitride region 21 such that the second opening 30 extends through second passivation layer 29 and the first passivation layer 24 and such that at least a portion of the first doped Group III nitride region 21 is exposed by the second opening 30. Similarly, a fifth opening 31 is formed which extends through the second passivation layer 29 and the underlying first passivation layer 24 and which exposes at least a portion of the second doped Group III nitride region 22 and a sixth opening 32 is formed through the second passivation layer 29 and the first passivation layer 24 which exposes at least a portion of the third doped Group III nitride region 23. The periphery of the first, second and third doped regions 21, 22, 23 remains covered by the first passivation layer 24 so that the second passivation layer 29 is no longer in direct contact wit the first major surface 11 or with the first, second and third doped regions 21, 22, 23.

The first opening 25 in the first passivation layer 24 and/or the second opening 30 in the second passivation layer 29 may be formed by plasma etching alone or wet etching alone or a combination of plasma etching and wet etching, for example, plasma etching followed by wet etching.

Referring to figure 2I, a metallic contact 33 is formed in the second opening which provides the gate metal of the gate structure. A metallic contact 34 is formed in the fifth opening 31 which provides a source contact and an ohmic contact to the second doped Group III nitride region 22 and the channel of the transistor device, e.g. the 2DEG. A metallic contact 35 is also formed in the 6 opening 32 which provides a drain contact of the transistor device and forms an ohmic contact to the third doped Group III nitride region 23 and the channel of the transistor device, e.g. the 2DEG.

The contact 33 may be formed in the second opening 30 by depositing at least one metallic layer 33 in the second opening 30 that is in contact with the doped Group III nitride region 21. In some embodiments, the at least one metallic layer 30 further extends over an upper surface 36 of the second passivation layer 29. The contact 33 provides the gate metal of the gate structure. The gate metal may be selected to provide an ohmic gate contact or a Schottky gate contact.

An ohmic gate metal may be used since the activation of the p-doped regions 21, 22, 23 is carried out before the deposition of the metallic layer(s) for the contacts. Consequently, the ohmic gate metal is not subjected to the higher temperatures of an annealing activation process.

Figure 3 illustrates a cross-sectional view of a semiconductor device 40" according to an embodiment which differs from that illustrated in figure1B and 2I in that it further comprises a third passivation layer 50 that is arranged on the second passivation layer 29. In this particular embodiment, the first passivation layer 24 is formed of Si₃N₄ and the second and third passivation layers 29, 50 are each formed of SiO₂. The third passivation layer 50 includes a first opening 51 that is located above the doped region 21 such that the first opening 51 is formed through the first and second and third passivation layers 24, 29, 50 which exposes the central portion 42 of the doped Group III nitride region 21. Only the first passivation layer 24 is in direct contact with the Group III nitride substrate 11. The peripheral region 41 of the doped Group III nitride region 21 is covered by and in direct contact with the first passivation layer 24. The gate metal 33 is located in the first opening 51 and is in contact with the first doped Group III nitride region 21.

Similarly, a second opening 52 is located above the second doped region 22 and extends through the first and second and third passivation layers 24, 29, 50. The second opening 52 exposes the central portion 42 of the second doped Group III nitride region 22. A third opening 53 is located above the third doped region 23, extends through the first and second and third passivation layers 24, 29, 50 which exposes the central portion 42 of the third doped Group III nitride region 22. The metallic contact 34 is arranged in the second opening to form a contact to the second doped Group III region 22 and the source contact and the metallic contact 35 is located in the third opening 53 to form a contact to the third doped Group III nitride region 23 and the drain contact. The gate metal layer 33 and/or one or both of the first and second metallic contacts 34, 35 further extends over an upper surface 54 of the third passivation layer 50.

The use of a hydrogen diffusion barrier material for the first passivation layer 24 also enables well-defined field plates to be integrated, for example the field plate 51 to be integrated near the gate G that extends over the upper surface of the first passivation layer 24, for example in the direction of the drain D. This integration of the field plates is enabled by the good process control possible when fabricating the first passivation layer 24, for example by LPCVD of a SiNₓ layer and the good dielectric quality and high density of these hydrogen diffusion barrier layers. The first passivation layer 24 may comprise SiNₓ, e.g. Si₃N₄ or may comprise Al₂O₃ or La₂O₃ or ZrO₂.

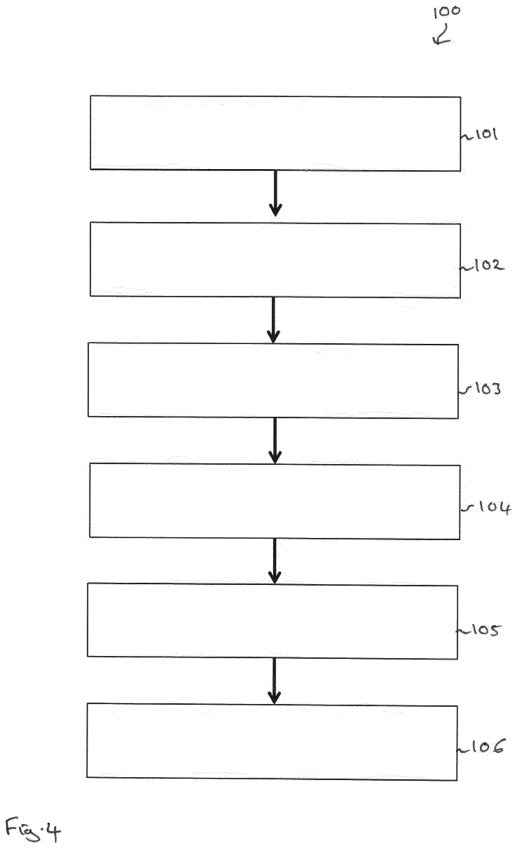

Figure 4 illustrates a flow diagram 100 of a method of fabricating a Group III nitride device. In box 101, a first passivation layer is formed on a first major surface of a Group III nitride-based substrate comprising at least one doped Group III nitride region comprising dopants of a first conductivity type, e.g. p-type. In box 102, at least one first opening is formed in the first passivation layer and at least a portion of the at least one doped Group III nitride region is exposed from the first passivation layer. In box 103, the first doped Group III nitride region is activated, for example by thermal annealing, whilst the first passivation layer is located on the first major surface and whilst the at least a portion of the at least one doped Group III nitride region is exposed from the first passivation layer. In box 104, a second passivation layer is formed on the first passivation layer and on the at least one doped Group III nitride region. In box 105, at least one second opening is formed in the first and second passivation layers and a portion of the at least one doped Group III nitride region is exposed. In box 106, an electrically conductive contact is formed in the second opening.

In this method, the doped Group III nitride region is passivated and opened twice in two independent steps. Therefore, the first passivation layer formed prior to activation and the second passivation layer formed after activation can be optimized for their respective roles. Each of the first and second dielectric layers may be formed of a single layer or may comprise two or more sublayers.

In this method only the surface region used for contacting is exposed from the first passivation layer 24 so that damage creation during activation in any region outside the exposed region (s) is avoided. This method may be used to fabricate Group III nitride switches, such as Group III transistor devices, e.g. Group III nitride HEMTs, or bidirectional switches. The switching devices may be enhancement mode or depletion mode devices. The method may be useful for Group III nitride devices comprising p-doped Group III nitride regions, for example a transistor device with a gate structure comprising a p-doped Group III nitride to provide an enhancement mode device. The method may also be useful for Group III nitride devices comprising an ohmic gate, including those comprising a p-doped Group III nitride and ohmic metal gate structure, since the ohmic metal id deposited after activation of the p-doped Group III nitride material. Transistor devices fabricated using this method have reduced gate leakage currents.

Although the present disclosure is not so limited, the following numbered examples demonstrate one or more aspects of the disclosure.

### Examples

Example 1. A method comprising:
providing a Group III nitride-based substrate comprising a first major surface and at least one doped Group III nitride region comprising dopants of a first conductivity type;
forming a first passivation layer on the first major surface, wherein the first passivation layer is configured as a hydrogen diffusion barrier;
forming at least one first opening in the first passivation layer and exposing at least a portion of the at least one doped Group III nitride region from the first passivation layer;
activating the first doped Group III nitride region whilst the first passivation layer is located on the first major surface and the at least a portion of the at least one doped Group III nitride region is exposed from the first passivation layer;
forming a second passivation layer on the first passivation layer and on the at least one doped Group III nitride region;
forming at least one second opening in the first and second passivation layers and exposing a portion of the at least one doped Group III nitride region,
forming a contact in the second opening.

Example 2. A method according to example 1, wherein the first passivation layer comprises Si₃N₄ or Al₂O₃ or La₂O₃ or ZrO₂.

Example 3. A method according to example 2, wherein the first passivation layer is formed by a LPCVD (Low Pressure Chemical Vapour Deposition) process and the LPCVD process comprises:
placing the Group III nitride substrate in an LPCVD furnace;
heating the Group III nitride substrate to a temperature of 800°C to 820°C in the LPCVD furnace;
providing ammonia gas and dichlorosilane gas to a reaction chamber at a ratio of 4 to 6, and at a pressure of 150 millitorr to 250 millitorr.

Example 4. A method according to any one of examples 1 to 3, wherein the first passivation layer comprises a silicon:nitrogen atomic ratio within 2 percent of the ratio 3:4.

Example 5. A method according to any one of examples 1 to 4, wherein the first passivation layer comprises a stress of 600 megapascals (MPa) to 1000 MPa; and a hydrogen content of less than 5 atomic percent;

Example 6. A method according to any one of examples 1 to 5, wherein the silicon nitride layer has an index of refraction of 2.0 to 2.1.

Example 7. A method according to any one of examples 1 to 6, wherein the first passivation layer has a dielectric breakdown strength of greater than 12 megavolts per centimetre (MV/cm).

Example 8. A method according to any one of examples 1 to 7, wherein the first passivation layer has a thickness of 5 nm to 30 nm.

Example 9. A method according to any one of examples 1 to 8, wherein the first passivation layer is formed of Si₃N₄ and the second passivation layer is formed of SiO₂.

Example 10. A method according to any one of examples 1 to 9, wherein one or both of the first and second openings are formed by plasma etching and/or wet etching.

Example 11. A method according to any one of examples 1 to 10, wherein the second opening is formed by plasma etching and subsequently wet etching.

Example 12. A method according to any one of examples 1 to 11, further comprising:
forming one or more of the at least one doped Group III nitride regions by depositing a Group III nitride layer on the first major surface of the Group III nitride-based substrate or in a recess formed in the first major surface of the Group III nitride-based substrate, and/or
forming one or more of the at least one doped Group III nitride regions in the Group III nitride-based substrate by implanting dopants of the second conductivity type into the first major surface of the Group III nitride-based substrate.

Example 13. A method according to any one of examples 1 to 12, wherein the activating the at least one doped Group III nitride region comprises thermally annealing the Group III nitride-based substrate.

Example 14. A method according to any one of examples 1 to 13, wherein the forming a contact in the second opening comprises:
depositing at least one metallic layer in the second opening that is in contact with the doped Group III nitride region.

Example 15. A method according to example 14, wherein the at least one metallic layer further extends over an upper surface of the second passivation layer.

Example 16. A method according to any one of examples 1 to 15, further comprising forming a third passivation layer over the second passivation layer, wherein the forming the second opening further comprises forming an opening in the first, second and third passivation layers and exposing at least a portion of the doped Group III nitride region.

Example 17. A method according to any one of examples 1 to 16, wherein the at least one metallic layer further extends over an upper surface of the third passivation layer.

Example 18. A method according to any one of examples 1 to 17, wherein a first doped Group III nitride region is formed by depositing a Group III nitride layer on the first major surface of the Group III nitride-based substrate or in a recess formed in the first major surface of the Group III nitride-based substrate and wherein the first doped Group III nitride region is configured as part of a gate structure.

Example 19. A method according to example 18, wherein the contact provides the gate metal of the gate structure and the gate metal provides an ohmic gate contact or a Schottky gate contact.

Example 20. A method according to example 18 or 19, further comprising forming a second doped Group III nitride region to provide a first ohmic contact and a third doped Group III nitride region to provide a second ohmic contact by implanting dopants of a second conductivity type into the first major surface of the Group III nitride substrate, wherein the first doped region is arranged laterally between the second and third doped Group III nitride regions.

Example 21. A method according to example 20, wherein
the first passivation layer is further formed on the second and third doped regions and a third opening and a fourth opening are formed in the first passivation layer and at least a portion of the second and third doped Group III nitride regions is exposed from the first passivation layer;
the first, second and third doped Group III nitride regions are activated whilst the first passivation layer is located on the first major surface and the at least a portion of the first, second and third doped Group III nitride regions is exposed from the first passivation layer;
the second passivation layer is formed on the first passivation layer and on the first, second and third doped Group III nitride regions,
the second opening, a fifth opening and a sixth opening are formed in the first and second passivation layers that expose the first, second and third Group III nitride doped region, respectively;
a gate contact is formed in the first opening, a first ohmic contact is formed in the fifth opening and a second ohmic contact is formed in the sixth opening.

Example 22. A method according to example 21, wherein the gate contact and the first and second ohmic contacts form a transistor device or a bidirectional switch.

Example 23. A method according to example 22, wherein the transistor device is a HEMT.

Example 24- A method according to any one of examples 1 to 23, wherein the doped Group III nitride region comprises p-doped GaN or p-doped AlGaN.

Example 25. A method according to any one of examples 1 to 24, wherein the Group III nitride-based substrate comprises a Group III nitride channel layer and a Group III nitride barrier layer arranged on the Group III nitride channel layer and forming a heterojunction therebetween.

Example 26. A method according to example 25, wherein the Group III nitride channel layer is formed of GaN and the Group III nitride barrier layer is formed of AlGaN.

Example 27. A method according to example 25 or example 16, wherein the Group III nitride channel layer is arranged on a buffer structure which is arranged on a base substrate.

Example 28. A method according to any one of examples 25 to 27, wherein the base substrate is formed of monocrystalline silicon, SiC or Sapphire.

Example 29. A semiconductor device, comprising:
a Group III nitride substrate comprising a first major surface;
at least one doped Group III nitride region formed in or on the first major surface;
a first passivation layer arranged on the first major surface and on a peripheral region of the doped Group III nitride region such that a central portion of the doped Group III nitride region is uncovered by the first passivation layer;
a metallic contact arranged in contact with the doped Group III nitride region and extending over the first passivation layer,
wherein the first passivation layer is configured as a hydrogen diffusion barrier.

Example 30. A semiconductor device according to example 29, wherein the first passivation layer comprises Si₃N₄ or Al₂O₃ or La₂O₃ or ZrO₂.

Example 31. A semiconductor device according to example 29 or example 30, further comprising a second passivation layer arranged on the first passivation layer and wherein the first passivation layer is formed of Si₃N₄ and the second passivation layer is formed of SiO₂.

Example 32. A semiconductor device according to any one of examples 29 to 31,
wherein the first passivation layer comprises a silicon : nitrogen atomic ratio within 2 percent of the ratio 3:4, and/or a stress of 600 megapascals (MPa) to 1000 MPa; and/or a hydrogen content of less than 5 atomic percent;

Example 33. A semiconductor device according to any one of examples 30 to 32, wherein the silicon nitride layer has an index of refraction of 2.0 to 2.1.

Example 34. A semiconductor device according to any one of examples 29 to 33,
wherein the first passivation layer has a dielectric breakdown strength of greater than 12 megavolts per centimetre (MV/cm).

Example 35. A semiconductor device according to any one of examples 29 to 34, wherein the first passivation layer has a thickness of 5 nm to 30 nm.

Example 36. A semiconductor device according to any one of examples 29 to 35, wherein
at least one of the doped Group III nitride regions comprises a doped Group III nitride layer that is arranged in a recess formed in the first major surface or is arranged on the first major surface and that is configured to provide a gate of a transistor device or a bidirectional switch, and/or
one or more of the doped Group III nitride regions is located in the Group III nitride substrate and provides an ohmic contact of a transistor device or a bidirectional switch.

Example 37. A semiconductor device according to example 36, wherein the transistor device is a HEMT.

Example 38. A semiconductor device according to any one of examples 29 to 37, wherein the doped Group III nitride region comprises p-doped GaN or p-doped AlGaN.

Example 39. A semiconductor device according to any one of examples 29 to 38, wherein the Group III nitride-based substrate comprises a Group III nitride channel layer and a Group III nitride barrier layer arranged on the Group III nitride channel layer and forming a heterojunction therebetween.

Example 40. A semiconductor device according to example 39, wherein the Group III nitride channel layer is formed of GaN and the Group III nitride barrier layer is formed of AlGaN.

Example 41. A semiconductor device according to example 39 or example 40, wherein the Group III nitride channel layer is arranged on a buffer structure which is arranged on a base substrate.

Example 42.A semiconductor device according to example 41, wherein the base substrate is formed of monocrystalline silicon, SiC or Sapphire.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A method comprising:
providing a Group III nitride-based substrate comprising a first major surface and at least one doped Group III nitride region comprising dopants of a first conductivity type;
forming a first passivation layer on the first major surface, wherein the first passivation layer is configured as a hydrogen diffusion barrier;
forming at least one first opening in the first passivation layer and exposing at least a portion of the at least one doped Group III nitride region from the first passivation layer;
activating the first doped Group III nitride region whilst the first passivation layer is located on the first major surface and the at least a portion of the at least one doped Group III nitride region is exposed from the first passivation layer;
forming a second passivation layer on the first passivation layer and on the at least one doped Group III nitride region;
forming at least one second opening in the first and second passivation layers and exposing a portion of the at least one doped Group III nitride region,
forming a contact in the second opening.

2. A method according to claims 1, wherein the first passivation layer comprises Si₃N₄ or Al₂O₃ or La₂O₃ or ZrO₂.

3. A method according to claim 2, wherein the first passivation layer is formed by a LPCVD (Low Pressure Chemical Vapour Deposition) process and the LPCVD process comprises:
placing the Group III nitride substrate in an LPCVD furnace;
heating the Group III nitride substrate to a temperature of 800°C to 820°C in the LPCVD furnace;
providing ammonia gas and dichlorosilane gas to a reaction chamber at a ratio of 4 to 6, and at a pressure of 150 millitorr to 250 millitorr.

4. A method according to any one of claims 1 to 3, wherein the first passivation layer is formed of Si₃N₄ and the second passivation layer is formed of SiO₂.

5. A method according to any one of claims 1 to 4, wherein one or both of the first and second openings are formed by plasma etching and/or wet etching.

6. A method according to any one of claims 1 to 5, further comprising:
forming one or more of the at least one doped Group III nitride regions by depositing a Group III nitride layer on the first major surface of the Group III nitride-based substrate or in a recess formed in the first major surface of the Group III nitride-based substrate, and/or
forming one or more of the at least one doped Group III nitride regions in the Group III nitride-based substrate by implanting dopants of the second conductivity type into the first major surface of the Group III nitride-based substrate.

7. A method according to any one of claims 1 to 6, wherein the activating the at least one doped Group III nitride region comprises thermally annealing the Group III nitride-based substrate.

8. A method according to any one of claims 1 to 7, wherein the forming a contact in the second opening comprises:
depositing at least one metallic layer in the second opening that is in contact with the doped Group III nitride region.

9. A method according to claim 8, wherein the at least one metallic layer further extends over an upper surface of the second passivation layer.

10. A method according to any one of claims 1 to 8, further comprising forming a third passivation layer over the second passivation layer, wherein the forming the second opening further comprises forming an opening in the first, second and third passivation layers and exposing at least a portion of the doped Group III nitride region.

11. A method according to any one of claims 1 to 10, wherein a first doped Group III nitride region is formed by depositing a Group III nitride layer on the first major surface of the Group III nitride-based substrate or in a recess formed in the first major surface of the Group III nitride-based substrate and wherein the first doped Group III nitride region is configured as part of a gate structure.

12. A method according to claim 11, wherein the contact provides the gate metal of the gate structure and the gate metal provides an ohmic gate contact or a Schottky gate contact.

13. A method according to claim 11 or 12, further comprising forming a second doped Group III nitride region to provide a first ohmic contact and a third doped Group III nitride region to provide a second ohmic contact by implanting dopants of a second conductivity type into the first major surface of the Group III nitride substrate, wherein the first doped region is arranged laterally between the second and third doped Group III nitride regions.

14. A method according to claim 13, wherein
the first passivation layer is further formed on the second and third doped regions and a third opening and a fourth opening are formed in the first passivation layer and at least a portion of the second and third doped Group III nitride regions is exposed from the first passivation layer;
the first, second and third doped Group III nitride regions are activated whilst the first passivation layer is located on the first major surface and the at least a portion of the first, second and third doped Group III nitride regions is exposed from the first passivation layer;
the second passivation layer is formed on the first passivation layer and on the first, second and third doped Group III nitride regions,
the second opening, a fifth opening and a sixth opening are formed in the first and second passivation layers that expose the first, second and third Group III nitride doped region, respectively;
a gate contact is formed in the first opening, a first ohmic contact is formed in the fifth opening and a second ohmic contact is formed in the sixth opening.

15. A method according to claim 14, wherein the gate contact and the first and second ohmic contacts form a transistor device or a bidirectional switch.
